# EUROPÄISCHE PATENTSCHRIFT

(11) **EP 2 910 225 B1**
(45) Veröffentlichungstag und Bekanntmachung des Hinweises auf die Patenterteilung: **20.04.2016**
(21) Anmeldenummer: 14156665.3
(22) Anmeldetag: 25.02.2014
(51) Int. Cl.: A61G 3/06, H03K 17/95

(54) **Klapprampe mit Sicherheitsschalter für Kraftfahrzeuge und Busse**
Folding ramp with safety switch for motor vehicles and buses
Rampe rabattable avec commutateur de sécurité pour véhicules automobiles et bus

(43) Veröffentlichungstag der Anmeldung: 26.08.2015
(73) Patentinhaber: Captron Electronic GmbH, 82140 Olching (DE)
(72) Erfinder: Bellm, Reinhard, 82110 Germering (DE)
(74) Vertreter: Lohr, Georg

(56) Entgegenhaltungen:
- DE-A1-102008 031 397
- DE-U1- 29 907 642
- DE-U1-202006 004 644

## Beschreibung

### Technisches Gebiet

Die Erfindung betrifft eine Klapprampe, welche einen barrierefreien Zugang zu Kraftfahrzeugen und Bussen ermöglicht. Eine solche Klapprampe kann bei angehaltenem Fahrzeug nach dem Öffnen einer Fahrzeugtüre aus dem Inneren des Fahrzeugs heraus geklappt werden und bildet einen relativ ebenen Zugang zum Fahrzeug ohne Stufen. Während der Fahrt liegt die Klapprampe im Inneren des Fahrzeugs auf dem Fahrzeugboden.

### Stand der Technik

In der EP 1 629 814 B1 ist eine Klapprampe für Fahrzeuge offenbart. Hierbei kann eine Rampenplatte mithilfe eines Scharniers aus dem Innenraum des Fahrzeugs heraus geklappt werden. Während der Fahrt liegt die Rampenplatte in einer Rampenwanne, die in den Fahrzeugboden eingelassen ist.

Eine weitere Klapprampe für Fahrzeuge ist in der DE 20 2006 004 644 U1 offenbart. Hier weist die Rampe einen Näherungsschalter auf, um festzustellen, ob die Rampenplatte in der Rampenwanne liegt. Der Näherungsschalter wird durch eine Klemmeinrichtung nahezu oberflächenbündig von einer Fläche der Rampenwanne gehalten. Dieser Sensor ist sehr empfindlich gegen Druckbelastung und kann insbesondere durch spitze Gegenstände leicht beschädigt werden.

Druckschrift DE 299 07 642 U1 offenbart einen Näherungsschalter mit einem Kunststoffgehäuse, wobei der Sensor selbst hinter einer keramischen Abdeckung sitzt. Hiermit soll der Sensor insbesondere vor Schweißspritzern, Schweißtropfen oder dergleichen geschützt werden, wie sie beim Punktschweißen entstehen.

Druckschrift DE 10 2008 031397 A1 offenbart eine Rampe für einen Kraftwagen, insbesondere für einen Omnibus, mit einer Rampenplatte, welche aus einer in einer Rampenaufnahme, insbesondere einer Rampenwanne, angeordneten Verstaustellung in eine Gebrauchsstellung bewegbar ist, und mit einer Ermittlungseinrichtung zum Erfassen der Stellung der Rampenplatte, welche einen Näherungssensor umfasst, dadurch gekennzeichnet, dass der Näherungssensor als Eisennäherungsschalter ausgebildet ist.

### Darstellung der Erfindung

Der Erfindung liegt die Aufgabe zugrunde, eine Klapprampe derart auszugestalten, dass eine ausgeklappte Rampe mit Sicherheit erkannt und ein Anfahren des Fahrzeugs zuverlässig verhindert werden kann. Weiterhin sollen auch keine fehlerhaften Anzeigen einer ausgeklappten Rampe erfolgen, wenn diese eingeklappt ist, da dies zu einem Ausfall des Fahrzeugs führen würde.

Diese Aufgabe wird durch eine Vorrichtung nach Anspruch 1 gelöst. Vorteilhafte Ausgestaltungen der Erfindung sind in den Unteransprüchen angegeben.

In diesem Dokument werden unter anderem Kraftfahrzeuge und Busse unter dem Begriff Fahrzeuge zusammengefasst. Eine Klapprampe weist eine Rampenwanne und eine Rampenplatte auf. Während der Fahrt liegt die Rampenplatte in der Rampenwanne. Bei angehaltenem Fahrzeug kann die Rampenplatte aus der Rampenwanne heraus nach außen geklappt werden. Nun ist das Fahrzeug über die Rampenplatte bzw. die Rampenwanne zugänglich. So können nun beispielsweise Fußgänger oder auch Rollstuhlfahrer über Rampenplatte bzw. Rampenwanne in das Innere des Fahrzeugs gelangen bzw. in umgekehrter Richtung das Fahrzeug verlassen. Ebenso können auch bequem Rollatoren und andere Gehhilfen in das Innere des Fahrzeugs geschoben werden.

Erfindungsgemäß ist im Boden der Rampenwanne ein induktiver Näherungssensor befestigt. Dadurch das Begehen bzw. Befahren der Rampenwanne besteht nun die Möglichkeit, dass auch über den Näherungssensor gerollt bzw. gelaufen wird. Somit kann der Näherungssensor zumindest kurzzeitig einer ganz erheblichen Krafteinwirkung von oben ausgesetzt sein. Bei konventionellen Sensoren ist ein induktiver Sensor, welcher beispielsweise ein Sensorelement umfassend wenigstens ein induktives Bauteil, wie einen Ferritkern, insbesondere einer Schalenkernhälfte umfasst, zusammen mit einer Ansteuerelektronik in einem becherförmigen Gehäuse vergossen. Eine Belastung von der Oberseite der Rampenwanne wirkt direkt auf das Sensorelement. Die Kraft wird weiter in das becherförmige Gehäuse eingeleitet und von dort weiter über ein Befestigungselement in die Rampenwanne geführt. Problematisch ist die direkte Krafteinleitung in das Sensorelement, wodurch die Lebensdauer und Zuverlässigkeit des Sensorelements deutlich reduziert wird.

Um eine Beschädigung oder sogar ein Abreißen des Sensors zu vermeiden, weist dieser erfindungsgemäß ein Gehäuse mit einer Abdeckkappe auf, wobei die Abdeckkappe vorzugsweise ein faserverstärktes Material, insbesondere einen Glasfaser- und/oder Kohlefaser- verstärkten Kunststoff aufweist. Hierbei überdeckt die Abdeckkappe nicht nur die Oberfläche des Sensorelements, sondern übergreift auch eine Öffnung zur Aufnahme des Näherungssensors in der Rampenwanne. Da die Abdeckkappe die Öffnungen an ihren Rändern übergreift, kann diese die Kräfte von oben seitlich in die Rampenwanne einleiten, sodass das Sensorelement selbst vor einer hohen Belastung geschützt ist.

Um ein einfaches manuelles Einklappen bzw. Ausklappen der Rampenplatte zu ermöglichen, wird versucht, diese mit einem möglichst niedrigen Gewicht auszugestalten. Daher werden vorzugsweise Materialien wie Kunststoffe oder auch Aluminium verwendet. Eisenhaltige Metalle werden aufgrund ihres hohen Gewichts vermieden. Moderne Rampenplatten haben daher eine Oberfläche aus Aluminium. Aluminiumplatten sind mit induktiven Näherungssensoren schwieriger zu detektieren als Stahlplatten. Daher wird bei bestehenden Rampenplatten häufig ein Stahlplättchen auf die Aluminiumoberfläche geschraubt oder geklebt, welches dann vom Sensor erkannt wird. Löst sich die Verklebung und fällt das Stahlplättchen ab, kann der Sensor den eingeklappten Zustand der Rampenplatte nicht mehr erkennen und zeigt fälschlicherweise eine ausgeklappte Rampe an. Dadurch wird eine Weiterfahrt des Fahrzeugs verhindert. Dieses besonders ärgerlich bei Nahverkehrsbussen, die in einer solchen Situation die Haltestelle nicht mehr verlassen können. Grundsätzlich kann auch eine Aluminium-Rampenplatte selbst durch einen induktiven Näherungssensor erkannt werden. Allerdings ist hierfür ein relativ großer Sensordurchmesser in einer Größenordnung von ca. 3 cm bis 6 cm notwendig. Je größer der Sensordurchmesser ist, umso leichter kann dieser auch beim Begehen bzw. Befahren beschädigt werden. Durch einen erfindungsgemäßen Sensor kann auch dieses Problem gelöst werden, so dass nun ohne Beschädigungsgefahr auch relativ große Sensoren eingesetzt werden können.

Ein weiteres Problem bei der Lageerkennung von Klapprampen ist der Schaltabstand. So sind gewisse mechanische Toleranzen in der Lagerung der Klapprampe unvermeidbar, sodass ein Schaltabstand, d.h. eine sichere Erkennung in einem Bereich von wenigstens 5 mm bis maximal 15 mm möglich sein muss. Für eine Erhöhung des Schaltabstandes muss auch der Sensordurchmesser vergrößert werden. Auch hier ermöglicht wieder ein erfindungsgemäßer Sensor eine Vergrößerung des Sensordurchmessers entsprechend größeren Schaltabständen. Zudem kann bei einem erfindungsgemäßen Sensor mit einer Abdeckkappe mit großem Durchmesser der Schaltabstand mechanisch dadurch reduziert werden, dass das Sensorelement innerhalb der Abdeckkappe aus der Oberfläche der Rampenwanne herausragt. Bei kleinem Sensordurchmesser würde bereits ein um nur wenige Millimeter aus der Oberfläche herausragendes Sensorelement deutlich stören. Ein größerer Durchmesser einer erfindungsgemäßen Abdeckkappe ermöglicht auch bei geringer Steigung des Randes der Abdeckkappe, diese deutlich über die Oberfläche der Rampenwanne hinausragen zu lassen.

Ein weiterer Aspekt Erfindung ist ein Sensor für Klapprampen entsprechend den hier beschriebenen Ausführungsformen.

### Beschreibung der Zeichnungen

Die Erfindung wird nachstehend ohne Beschränkung des allgemeinen Erfindungsgedankens anhand von Ausführungsbeispielen unter Bezugnahme auf die Zeichnungen exemplarisch beschrieben.
- Figur 1: zeigt eine erfindungsgemäße Klapprampe mit Sensor.
- Figur 2: zeigt einen in eine Rampenplatte integrierten Sensor in Seitenansicht.
- Figur 3: zeigt einen Sensor in Schrägansicht von oben.
- Figur 4: zeigt einen Sensor in Schrägansicht von unten.
- Figur 5: zeigt einen Sensor von unten.

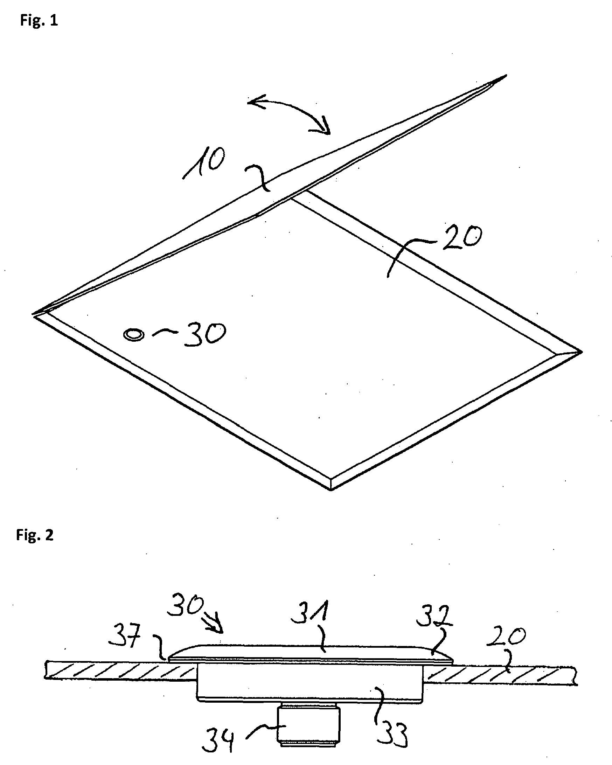

In Figur 1 ist eine erfindungsgemäße Klapprampe umfassend eine Rampenplatte 10 sowie eine Rampenwanne 20 dargestellt. Es ist weiterhin ein in die Rampenwanne 20 integrierten Sensor 30 dargestellt. Die Rampenplatte kann hier in Pfeilrichtung geschwenkt werden. In der Ruhelage liegt die Rampenplatte 10 flächig in der Rampenwanne 20.

In der Figur 2 ist eine Rampenplatte 20 mit integriertem Sensor 30 in seitlicher Ansicht dargestellt. Der Sensor 30 ist in einer Öffnung innerhalb der Rampenplatte befestigt. Er hat eine Abdeckkappe 31 mit einem Tragrand 32. Der Tragrand 32 ist fester Bestandteil der Abdeckkappe 31. Die Abdeckkappe 31 weist vorzugsweise ein faserverstärktes Material, wie beispielsweise Faser oder kohlefaserverstärktem Kunststoff auf. Die Abdeckkappe nimmt Druck von oben auf und leitet ihn mittels des Tragrands 32 in die Rampenwanne 20 ein. Die Abdeckkappe ist bevorzugt mittels eines Klebebands 37 an der Rampenwanne befestigt. Alternativ kann zwischen der Abdeckkappe und der Rampenwanne ein Dichtring vorgesehen sein. Die Hauptbelastung erfolgt von oben durch betreten oder überfahren der Abdeckkappe. In entgegengesetzter Richtung wirken nur geringe Kräfte auf die Abdeckkappe. Daher muss nur ein Herausfallen der Abdeckkappe mit Sensorelement aus der Öffnung in der Rampenwanne verhindert werden. Dies kann im einfachsten Falle mittels eines Klebebands 37 erfolgen. Alternativ können auch Befestigungsclips oder ein Sicherungsgewinde verwendet werden. An der Abdeckkappe 31 ist ein Sensorgehäuse 33 angeordnet, welches das Sensorelement bzw. die hierfür notwendigen elektronischen Komponenten enthält. Da das Sensorgehäuse am Rand der Abdeckkappe selbst hält, nimmt dieses bei einer Belastung von oben keine Kraft auf. Ein im Sensorgehäuse befestigtes Sensorelement ist bevorzugt mechanisch von der Abdeckkappe 31 selbst entkoppelt, sodass auch eine geringfügige Verformung der Abdeckkappe 31 durch Belastung keine Belastung des im Sensorgehäuse befindlichen Sensors verursacht. Zum elektrischen Anschluss des Sensors ist bevorzugt ein Anschlussstecker 34 vorgesehen. Alternativ hierzu kann auch ein Kabelabgang vorhanden sein. Dieser weist bevorzugt eine Zugentlastung auf.

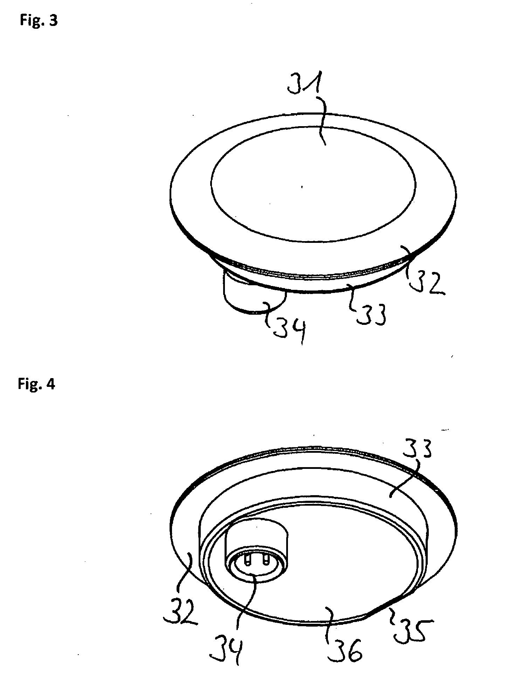

In der Figur 3 ist ein Sensor in einer Schrägansicht von oben dargestellt. In diesem Ausführungsbeispiel ist der Tragrand 32 seitlich angeschrägt, während der Rest der Abdeckkappe 31 eben verläuft. Stattdessen kann auch die übrige Abdeckkappe eine angeschrägte oder gewölbte Oberfläche aufweisen.

In Figur 4 ist ein Sensor in einer Ansicht schräg von unten dargestellt. Hier ist ein Gehäusedeckel 36 erkennbar, der das Gehäuse nach unten, also zu der von der Abdeckkappe abgewandten Seite abschließt. Anstelle eines Gehäusedeckels kann die hier nicht dargestellte Sensorelektronik bzw. das Sensorelement durch eine Vergussmasse gegen die Umgebung abgeschlossen sein.

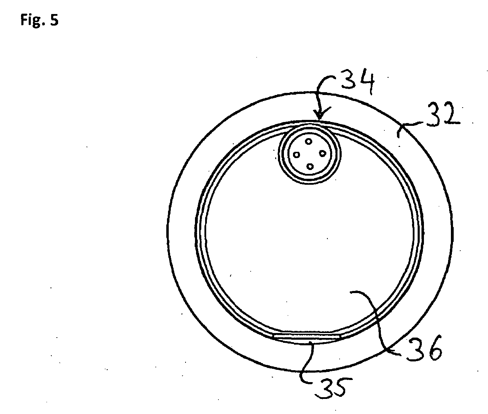

Die Figur 5 zeigt einen Sensor von unten. Hier ist zusätzlich noch eine optionale Verdrehsicherung 35 in Form einer Abflachung des Sensorgehäuses dargestellt.

### Bezugszeichenliste

- 10: Rampenplatte
- 20: Rampenwanne
- 30: Sensor
- 31: Abdeckkappe
- 32: Tragrand
- 33: Sensorgehäuse
- 34: Anschlussstecker
- 35: Verdrehsicherung
- 36: Gehäusedeckel
- 37: Abdichtung/Klebeband

## Patentansprüche

1. Klapprampe für Fahrzeuge umfassend eine Rampenplatte (10) sowie eine Rampenwanne (20) mit wenigstens einem in die Rampenwanne (20) integrierten induktiven Sensor (30), **dadurch gekennzeichnet, dass** der Sensor (30) eine Abdeckkappe (31) aufweist, die mit einem Tragrand (32) eine Aussparung in der Rampenwanne (20) zur Aufnahme des Sensors (30) übergreift.

2. Klapprampe nach Anspruch 1,
**dadurch gekennzeichnet, dass**
ein Sensorelement umfassend wenigstens ein induktives Bauteil unter der Abdeckkappe (31) angeordnet ist, ohne jedoch in unmittelbarem mechanischen Kontakt mit dieser zu stehen.

3. Klapprampe nach Anspruch 2,
**dadurch gekennzeichnet, dass**
das Sensorelement durch ein Sensorgehäuse (33) mit der Abdeckkappe (31) verbunden ist.

4. Klapprampe nach einem der vorhergehenden Ansprüche,
**dadurch gekennzeichnet, dass**
die Abdeckkappe (31) ein faserverstärktes Material umfasst.

5. Klapprampe nach Anspruch 4,
**dadurch gekennzeichnet, dass**
die Abdeckkappe (31) einen glasfaserverstärkten oder kohlefaserverstärkten Kunststoff umfasst.

## Claims

1. Folding ramp for vehicles comprising a ramp plate (10) and a ramp pan (20) with at least one inductive sensor (30) integrated in the ramp pan (20),
**characterized in that**
the sensor (30) comprises a cover cap (31) which overlaps with a supporting edge (32) a recess in the ramp trough (20) for receiving the sensor (30).

2. Folding ramp according to claim 1,
**characterized in that**
a sensor element comprising at least one inductive component is arranged below the cover cap (31), but without being in direct mechanical contact therewith.

3. Folding ramp according to claim 2,
**characterized in that**
the sensor element is connected to the cover cap (31) via a sensor housing (33).

4. Folding ramp according to any one of the preceding claims,
**characterized in that**
the cover cap (31) comprises a fiber-reinforced material.

5. Folding ramp according to claim 4,
**characterized in that**
the cover cap (31) comprises a glass-fiber-reinforced or carbon-fiber-reinforced plastic.

## Revendications

1. Rampe repliable pour véhicules comprenant un plateau de rampe (10) et un pan de rampe (20) avec au moins un capteur à induction (30) intégré dans le pan de rampe (20), **caractérisée en ce que** le capteur (30) présente un capuchon (31) dont un bord portant (32) recouvre une découpe dans l'auge de vanne (20) destinée à recevoir le capteur (30).

2. Rampe repliable selon la revendication 1, **caractérisée en ce qu'**un élément de capteur comprenant au moins un composant inductif est disposé sous le capuchon (31), sans toutefois être en contact mécanique direct avec celui-ci.

3. Rampe repliable selon la revendication 2, **caractérisée en ce que** l'élément de capteur est relié par un boîtier de capteur (33) au capuchon (31).

4. Rampe repliable selon l'une des revendications précédentes, **caractérisée en ce que** le capuchon (31) comporte un matériau armé de fibres.

5. Rampe repliable selon la revendication 4, **caractérisée en ce que** le capuchon (31) comporte un matériau armé de fibres de verre ou de fibres de carbone.
